# EUROPEAN PATENT APPLICATION

(11) **EP 2 439 844 A2**
(43) Date of publication of application: **11.04.2012**
(21) Application number: 11167021.2
(22) Date of filing: 23.05.2011
(51) Int. Cl.: H03H 3/04, H03H 9/13, H03H 9/58, H03H 9/02

(54) **Bulk acoustic wave resonator, bulk acoustic wave filter and their corresponding methods of manufacture**

(30) Priority: 11.10.2010 TW 099134586
(71) Applicant: RichWave Technology Corp., Taipei City 114 (TW)
(72) Inventor: Mao, Shau-Gang, Taipei City 106 (TW); Deng, Wei-Kung, 325, Taoyuan County (TW)
(74) Representative: Becker Kurig Straus

(57) **Abstract**

A bulk acoustic wave (BAW) resonator (38) includes a substrate (30), and two electrodes (32, 36) stacked on the substrate (30), and at least one piezoelectric layer (34) interposed between the two electrodes (32, 36). The two electrodes (32, 36) and the piezoelectric layer (34) are at least partially overlapped with each other in a vertical projection direction, and one of the two electrodes (32, 36) has a plurality of openings (32A, 36A).

## Description

### Field of the Invention

The present invention relates to a bulk acoustic wave resonator, a bulk acoustic wave filter and a method of fabricating a bulk acoustic wave resonator. More particularly, The present invention relates to a bulk acoustic wave resonator with a grid pattern electrode and a method of fabricating the same, a bulk acoustic wave filter with input/output end disposed in different layers, and a bulk acoustic wave filter having a plurality of bulk acoustic wave resonators disposed in a multilayer stacked-up configuration, wherein the piezoelectric layers of the bulk acoustic wave resonators in a same layer are interconnected to form a complete piezoelectric layer according to the pre-characterizing clauses of claims 1, 3, 7, 14, 15, 21 and 22.

### Background of the Invention

Due to high efficiency, bulk acoustic wave resonators (BAW resonators) are widely applied in a variety of electronic products. For example, bulk acoustic wave resonators may realize bulk acoustic wave filters (BAW filters) applied in band-pass filters of communication products.

For applications of band-pass filters, the specification for the frequency of bulk acoustic wave resonators is strictly demanded. The frequency of the bulk acoustic wave resonator is mainly determined by the dielectric constant and the thickness of the piezoelectric material and the area overlapped by both of the two electrodes. During the process of fabricating the bulk acoustic wave resonator, the dielectric constant of the piezoelectric layer can be determined by the selected materials. However, the thickness of the piezoelectric layer and the area overlapped by both of the two electrodes may be different from the predetermined values due to the variations during the fabrication process. Compared with the precision of the photolithography currently used to define patterns of the electrode, the precision of the deposition process for forming the piezoelectric layer is relatively worse so that the variation in thickness of the piezoelectric layer becomes one of the main reasons why the frequency of the bulk acoustic wave resonator can not be precisely controlled during the process of fabricating the bulk acoustic wave resonator. As a result, the current yield rate and the reliability of the bulk acoustic wave resonator are unsatisfactory.

### Summary of the Invention

This in mind, the present invention aims at providing a bulk acoustic wave resonator, a bulk acoustic wave filter, and a method of fabricating a bulk acoustic wave resonator, for improving the yield rate and the reliability of the bulk acoustic wave resonator, enhancing the flexibility of circuit designs, and reducing the process steps.

This is achieved by a bulk acoustic wave resonator, a bulk acoustic wave filter, and a method of fabricating a bulk acoustic wave resonator according to the pre-characterizing clauses of claims 1, 3, 7, 14, 15, 21 and 22. The dependent claims pertain to corresponding further developments and improvements.

As will be seen more clearly from the detailed description following below, a bulk acoustic wave resonator is provided. The bulk acoustic wave resonator comprises a substrate, two electrodes stacked on the substrate, and at least one piezoelectric layer interposed between the two electrodes. The two electrodes and the piezoelectric layer at least partially overlap with each other in a vertical projection direction, and one of the two electrodes has a plurality of openings

### Brief Description of the Drawings

In the following, the invention is further illustrated by way of example, taking reference to the accompanying drawings. Thereof
FIG. 1-3 are schematic diagrams illustrating a method of fabricating a bulk acoustic wave resonator according to a preferred embodiment of the present invention,
FIG. 4 and FIG. 5 are schematic diagrams illustrating the frequency tuning steps according to two preferred embodiments of the present invention,
FIG. 6 is a schematic diagram illustrating an alternative mode of the electrode pattern according to the present invention,
FIG. 7 and FIG. 8 are schematic diagrams illustrating a bulk acoustic wave filter according to a preferred embodiment of the present invention,
FIG. 9 and FIG. 10 are schematic diagrams illustrating the bulk acoustic wave filters according to two alternative modes of the embodiment illustrated in FIG. 7,
FIG. 11 is a schematic diagram illustrating a bulk acoustic wave filter according to an alternative mode of the embodiment illustrated in FIG. 8,
FIG. 12 is a schematic diagram illustrating a bulk acoustic wave filter according to another preferred embodiment of the present invention,
FIG. 13 is a schematic diagram illustrates a bulk acoustic wave filter and a method of fabricating the same according to another preferred embodiment of the present invention,
FIG. 14 is a schematic diagram illustrating a bulk acoustic wave filter and a method of fabricating the same according to further another preferred embodiment of the present invention, and
FIG. 15 is a schematic diagram illustrating the relationship between the amplitude and the frequency of the signals processed by the bulk acoustic wave filter.

### Detailed Description

To provide a better understanding of the present invention to the skilled users in the technology of the present invention, preferred embodiments will be detailed as follows. The preferred embodiments of the present invention are illustrated in the accompanying drawings with numbered elements to elaborate the contents and effects to be achieved.

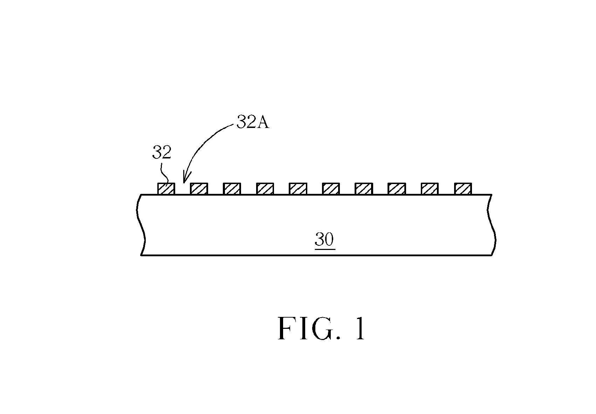

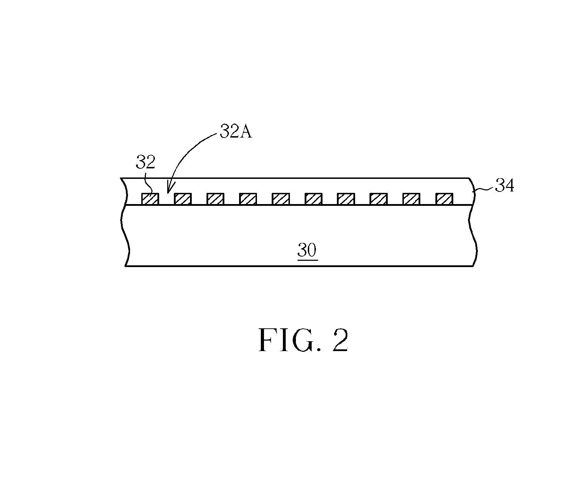

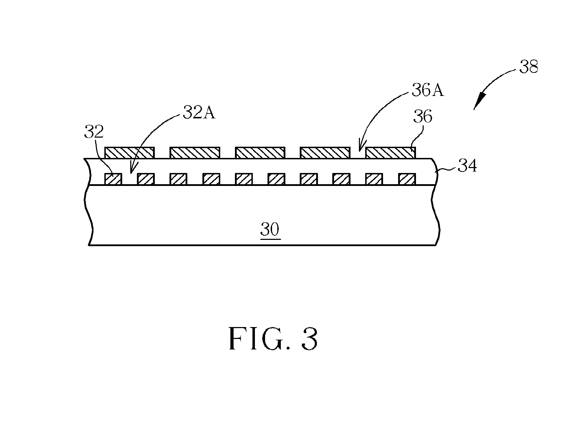

Please refer to FIGs. 1-3. FIGs. 1-3 are schematic diagrams illustrating a method of fabricating a bulk acoustic wave resonator according to a preferred embodiment of the present invention. As shown in FIG. 1, a substrate 30 is provided first, wherein the substrate 30 may be a semiconductor substrate such as a silicon substrate, the present invention is not limited to this. Then an electrode (referred as first electrode 32 thereinafter) is formed on the substrate 30. It is worth mentioning that at least one piezoelectric layer (not shown) or a dielectric layer (not shown) can selectively be formed on the substrate 30 prior to the formation of the first electrode 32, but the present invention is not limited to this. As shown in FIG. 2, at least one piezoelectric layer 34 is then formed on the first electrode 32, wherein the piezoelectric layer 34 may be made of any piezoelectric material such as aluminum nitride, and the piezoelectric layer 34 may be formed by any fabricating process, for example, physical vapor deposition (PVD) or chemical vapor deposition (CVD). As shown in FIG. 3, another electrode (referred as second electrode 36 thereinafter) is then formed on the piezoelectric layer 34, to form a bulk acoustic wave resonator 38. The first electrode 32 and the second electrode 36 may be made of any conductive material, such as silver. According to the present invention, at least one of the first electrode 32 and the second electrode 36 may have a plurality of openings. For example, in this embodiment, the first electrode 32 has openings 32A, and the second electrode 36 also has openings 36A. Since the openings 32A and the openings 36A are respectively grid patterns, the first electrode 32 and the second electrode 36 may respectively be a grid pattern electrode, but the present invention is not limited to this. In addition, the first electrode 32, the piezoelectric layer 34 and the second electrode 36 at least partially overlap each other in a vertical projection direction, and the pattern of the first electrode 32 and the pattern of the second electrode 36 may be identical or different depending on different design purposes.

The frequency of bulk acoustic wave resonator 38 is related to the capacitance, the inductance and the resistance. The capacitance, the inductance, and the resistance are determined by the thickness of piezoelectric layer 34 as well as an area overlapped by both the first electrode 32 and the second electrode 36. Since the process precision of the piezoelectric layer 34 is worse and there may be other unpredictable factors, the value of the actual frequency of the manufactured bulk acoustic wave resonator 38 usually varies from the value of the target frequency. To solve this problem, the method of fabricating a bulk acoustic wave resonator in this embodiment further comprises a measuring step and a frequency tuning step. The measuring step is used to measure the actual frequency of the bulk acoustic wave resonator 38. It is worth mentioning that the measuring step can be preformed after the completion of the bulk acoustic wave resonator 38, but the present invention is not limited to this. For example, the value of the frequency of the bulk acoustic wave resonator 38 also can be calculated by simulations or other approaches during the manufacturing process of the bulk acoustic wave resonator 38. The bulk acoustic wave resonator 38 may be judged qualified, when the measured value of the actual frequency equals to the value of the target frequency, or the difference is within a permissible range. When the difference between the actual frequency and the target frequency is considerable, a frequency tuning step may be preformed to adjust the actual frequency of bulk acoustic wave resonator 38 to be close to or equal to the target frequency.

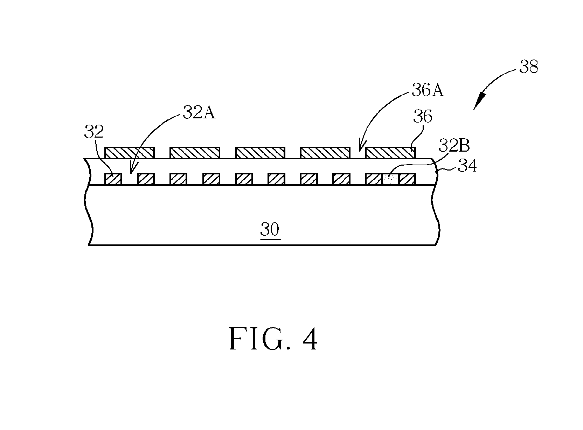

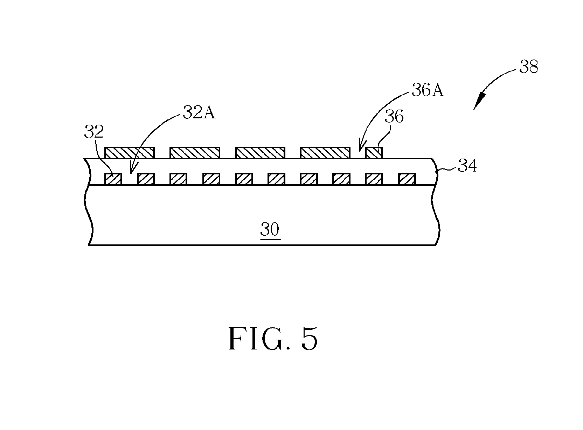

In this embodiment, the frequency tuning step comprises adjusting an area of the first electrode 32 and/or adjusting an area of the second electrode 36, such as increasing or decreasing the area of the first electrode 32, or increasing or decreasing the area of the second electrode 36, but the present invention is not limited to this. The means for adjusting the area of the first electrode 32 and/or adjusting the area of the second electrode 36 can be such as adjusting the number of the openings 32A and the number of the openings 36A. Please refer to FIG. 4 and FIG. 5. FIG. 4 and FIG. 5 are schematic diagrams illustrating the frequency tuning steps according to two preferred embodiments of the present invention. As shown in FIG. 4, the frequency tuning step in this embodiment is performed by adjusting the area of the first electrode 32. For example, a compensation pattern 32B may be filled in the opening 32A of first electrode 32 to increase the area of the first electrode 32. Therefore, the number of the openings 32A will be decreased and the area overlapped by both the first electrode 32 and the second electrode 36 will be changed to adjust the capacitance, the inductance or the resistance of the bulk acoustic wave resonator 38. Thus the actual frequency of the bulk acoustic wave resonator 38 may be adjusted. As shown in FIG. 5, according to this embodiment, the frequency tuning step is preformed by adjusting the area of the second electrode 36. For example, a part of second electrode 36 may be removed to increase the number of the openings 36A. Therefore, the area of the second electrode 36 will be decreased, and the area overlapped by the first electrode 32 and the second electrode 36 will be modified to adjust the capacitance, the inductance or the resistance. Thus the actual frequency of bulk acoustic wave resonator 38 may be adjusted. In the two embodiments mentioned above, for modifying the area of the first electrode 32 and the second electrode 36, a process such as a deposition process may be used to increase the area of the first electrode 32 and the second electrode 36, or a process such as an etching process may be used to decrease the area of the first electrode 32 and the second electrode 36, but the present invention is not limited to this. Additionally, it is worth mentioning that patterned electrodes are used in the bulk acoustic wave resonator 38 according to this embodiment, i.e., the first electrode 32 has the openings 32A and the second electrode 36 has the openings 36A. The patterned electrodes are beneficial for the frequency tuning steps, and make it easier to realize the modification of the area overlapped by the first electrode 32 and the second electrode 36. It is worth mentioning that in other embodiments according to the present invention, a planar first electrode 32 and a planar second electrode 36 may be formed first, and then the openings 32A and/or the openings 36A may be formed during the frequency tuning steps.

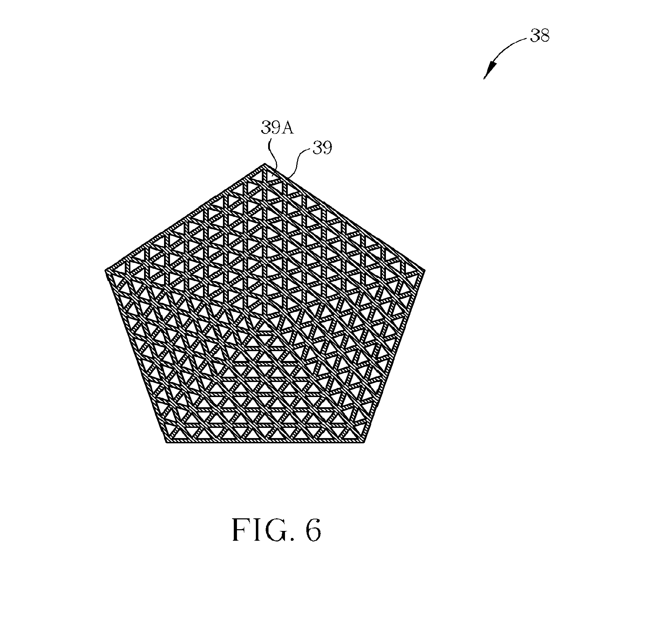

It is worth mentioning that the pattern of the first electrode or the second electrode of the bulk acoustic wave resonator according to the present invention is not limited to rectangular grid pattern electrodes and may be other shape according to different design purposes. Please refer to FIG. 6. FIG. 6 is a schematic diagram illustrating an alternative mode of the electrode pattern according to the present invention. As shown in FIG. 6, the difference from the above-mentioned embodiments is that in this embodiment, the electrode 39 is a polygon such as a pentagon, and the electrode 39 has a plurality of openings 39A, wherein the openings 39A are triangles, but the present invention is not limited to this.

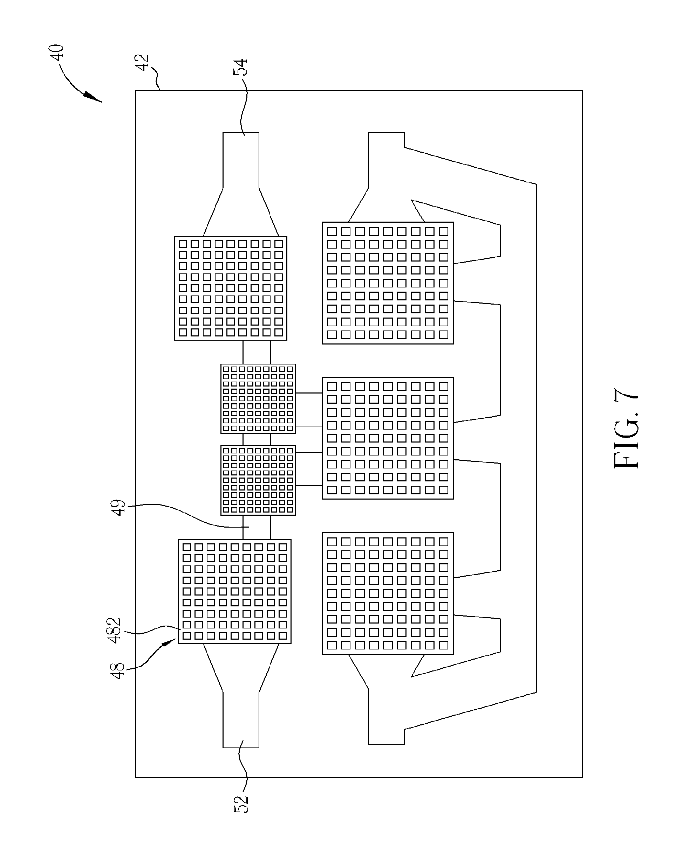

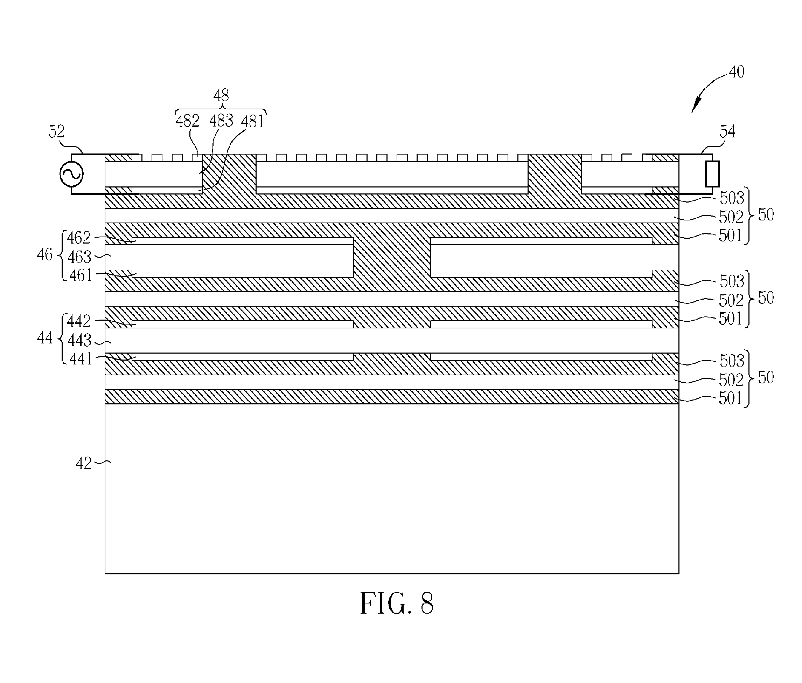

Please refer to FIG. 7 and FIG. 8. FIG. 7 and FIG. 8 are schematic diagrams illustrating a bulk acoustic wave filter according to a preferred embodiment of the present invention. FIG. 7 is a schematic diagram illustrating a top view of the bulk acoustic wave filter, and FIG. 8 is a schematic diagram illustrating a cross-sectional view of the bulk acoustic wave filter. As shown in FIG. 7 and FIG. 8, the bulk acoustic wave filter 40 in this embodiment comprises a substrate 42, a plurality of bulk acoustic wave resonators disposed on the substrate 42 in a multilayer stacked-up configuration, wherein the bulk acoustic wave resonators transmit a signal by coupling, such as acoustical coupling or electrical coupling. In this embodiment, the plurality of bulk acoustic wave resonators comprise a plurality of first bulk acoustic wave resonators 44 disposed on the substrate 42, a plurality of second bulk acoustic wave resonators 46 stacked on the first bulk acoustic wave resonators 44, and a plurality of third bulk acoustic wave resonators 48 stacked on the second bulk acoustic wave resonators 46, i.e., the bulk acoustic wave filter 40 in this embodiment has bulk acoustic wave resonators in a three layered stacked-up configuration. Each of the first bulk acoustic wave resonators 44 comprises a first electrode 441, a second electrode 442 disposed on the first electrode 441, and at least one piezoelectric layer 443 interposed between the first electrode 441 and the second electrode 44. Each of the second bulk acoustic wave resonators 46 comprises a first electrode 461, a second electrode 462 disposed on the first electrode 461, and at least one piezoelectric layer 463 interposed between the first electrode 461 and the second electrode 462. Each of the third bulk acoustic wave resonators 48 comprises a first electrode 481, a second electrode 482 disposed on the first electrode 481, and at least one piezoelectric layer 483 interposed between the first electrode 481 and the second electrode 482.

In addition, there is a conducting wire 49 coupled between electrodes of the bulk acoustic wave resonators in the same layer, as shown in FIG. 7. The conducting wire 49 may be formed as a part of a capacitor, an inductor, or a resistor. A capacitance, an inductance or a resistance may be influenced by a length, a width, a thickness, a shape, and a trace pattern of the conducting wire 49. Therefore, for designing the bulk acoustic wave filter 40, the length, the width, the thickness, the shape and the trace pattern of the conducting wire 49 should be considered and modified appropriately. For example, as shown in FIG. 7, in this embodiment, the trace pattern of the conducting wire 49 is a straight line, but the present invention is not limited to this. The length, the width, the shape, and the thickness of the conducting wire 49 may be adjusted depending on the requirements for the capacitance, the inductance and the resistance. Furthermore, a interposer layer 50 may be disposed between the bulk acoustic wave resonators in different layers, and between the substrate 42 and the bulk acoustic wave resonators in the bottom layer (the first bulk acoustic wave resonator 44 in this embodiment). The interposer layer 50 may be a single interposer layer or a composite interposer layer. As a single interposer layer is used, the interposer layer 50 may be a piezoelectric layer or a dielectric layer with appropriate impedance. As a composite interposer layer is used, the interposer layer 50 comprises a plurality of stacked material layers with different impedance values. For example, in this embodiment, the interposer layer 50 comprises a first material layer 501, a second material layer 502 and a third material layer 503, wherein the first material layer 501, the second material layer 502 and the third material layer 503 have different impedance values, and the first material layer 501, the second material layer 502 and the third material layer 503 may respectively be a piezoelectric layer or a dielectric layer. In addition, the bulk acoustic wave filter 40 further comprises an input end 52 and an output end 54 for receiving input signals to be filtered and transmitting the filtered signals. In this embodiment, the input end 52 and output end 54 are electrically connected to the bulk acoustic wave resonators in the same layer, for example, being electrically connected to two corresponding third bulk acoustic wave resonators 48, but the present invention is not limited to this.

In this embodiment, any one of the first bulk acoustic wave resonators 44 in the bottom layer, any one of the second bulk acoustic wave resonators 46 in the middle layer, and any one of the third bulk acoustic wave resonators 48 in the top layer may have patterned electrodes described in above-mentioned embodiments in FIGs. 1-5. For example, in this embodiment, the second electrode 482 of the third bulk acoustic wave resonator 48 is a grid pattern electrode.

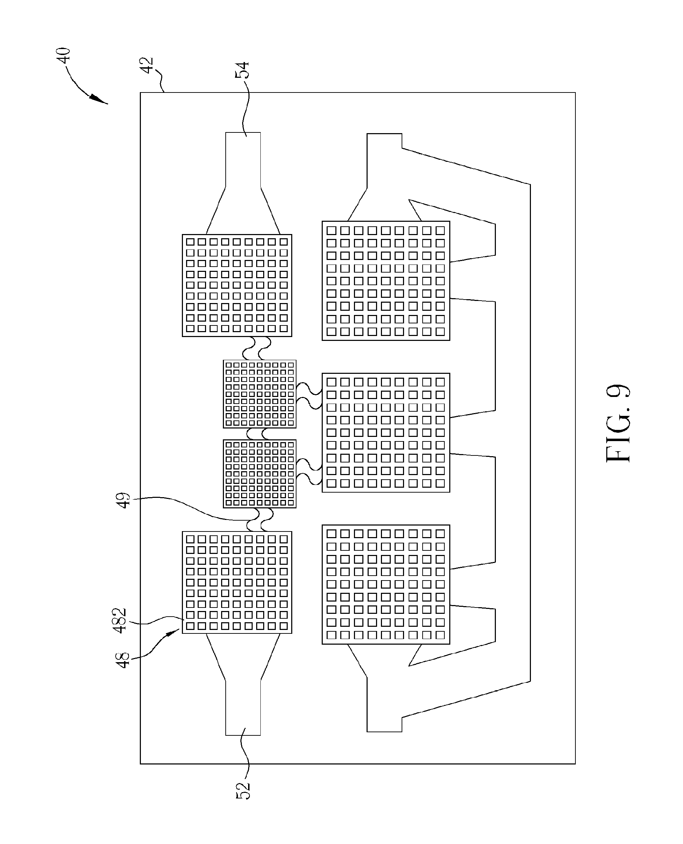

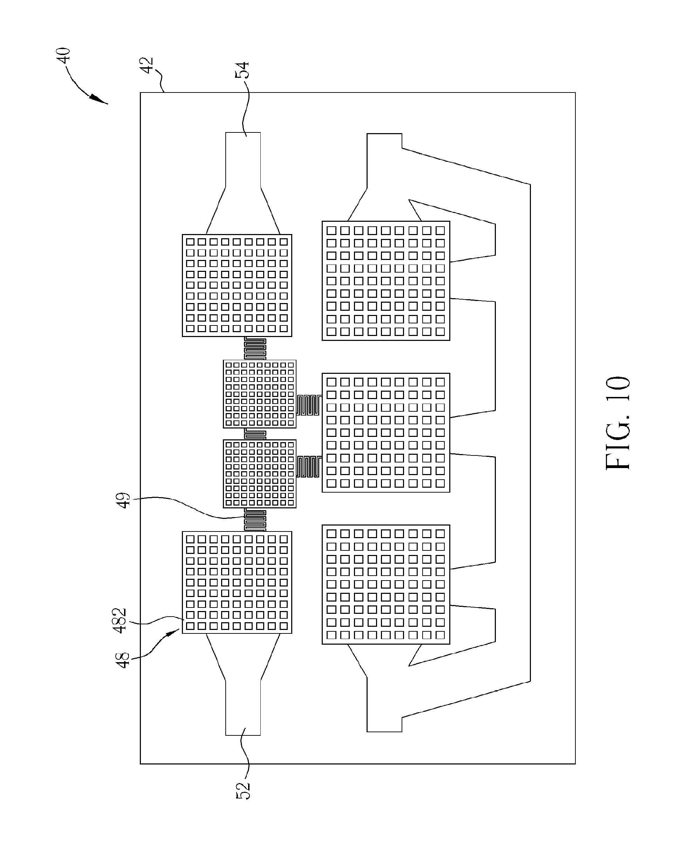

Please refer to FIG. 9 and FIG. 10. FIG. 9 and FIG. 10 are schematic diagrams illustrating the bulk acoustic wave filters according to two alternative modes of the embodiment illustrated in FIG. 7. As shown in FIG. 9, compared with the embodiment in FIG. 7, in this alternative mode, the trace pattern of a part of the conducting wire 49 may be a meander pattern, such as a pattern of S, but the present invention is not limited to this. The length, the width, the shape and the thickness of the conducting wire 49 may be adjusted depending on the requirements for the capacitance, the inductance and the resistance. As shown in FIG. 10, compared with the embodiment in FIG. 7, in this alternative mode, the trace pattern of a part of the conducting wire 49 is a winding pattern, such as a winding pattern wound with right angles, but the present invention is not limited to this.

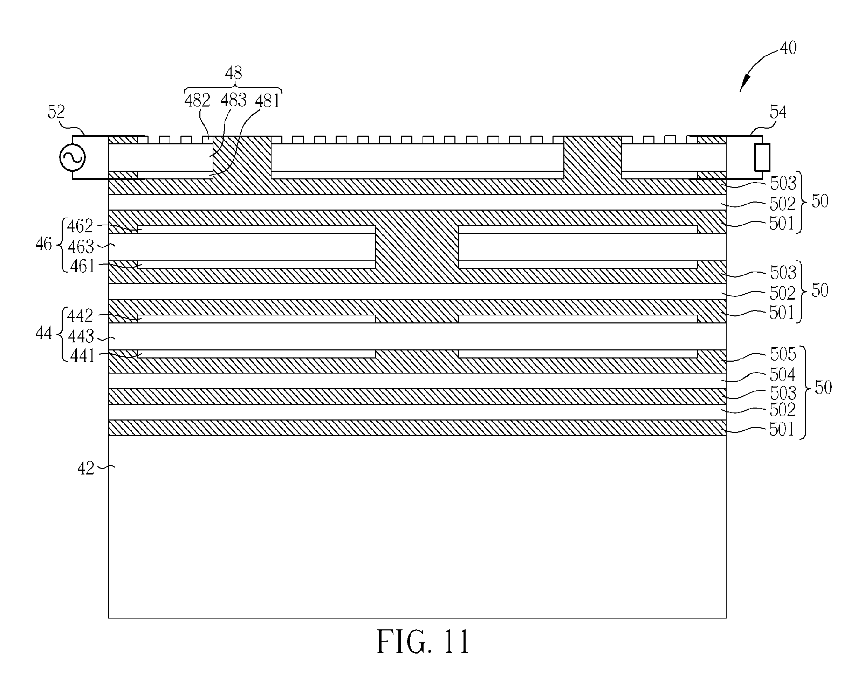

Please refer to FIG. 11. FIG. 11 is a schematic diagram illustrating a bulk acoustic wave filter according to an alternative mode of the embodiment illustrated in FIG. 8. As shown in FIG. 11, compared with the embodiment in FIG. 8, in this alternative mode, a interposer layer 50 between the first bulk acoustic wave resonator 44 and the substrate 42 may comprise a first material layer 501, a second material layer 502, a third material layer 503, a fourth material layer 504, and a fifth material layer 505, wherein the first material layer 501, the second material layer 502, the third material layer 503, the fourth material layer 504 and the fifth material layer 505 have different impedance values, and the first material layer 501, the second material layer 502, the third material layer 503, the fourth material layer 504 and the fifth material layer 505 may respectively be a piezoelectric layer or a dielectric layer. It is worth mentioning that, according to the present invention, the material, the thickness and the number of layers of the composite interposer layer may be adjusted according to the requirements, without being limited to those approaches described in the above-mentioned embodiments.

The following description will detail the different embodiments of the bulk acoustic wave filters in the present invention. To make it more convenient to compare between the dissimilarities among different embodiments and to simplify the description, the identical components will be marked with the same symbols, and the following description will detail the dissimilarities among different embodiments. The identical components will not be redundantly described.

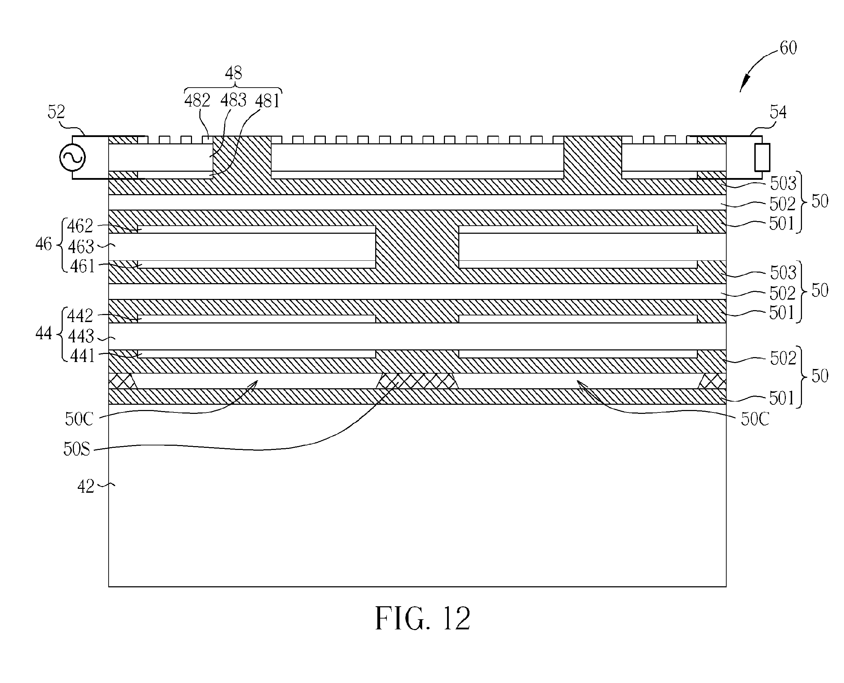

Please refer to FIG. 12. FIG. 12 is a schematic diagram illustrating a bulk acoustic wave filter according to another preferred embodiment of the present invention. As shown in FIG. 12, in this embodiment, the interposer layer 50 of the bulk acoustic wave filter 60 has a cavity 50C. More specifically, the interposer layer 50 between the first bulk acoustic wave resonator 44 and substrate 42 may comprise a first material layer 501, a second material layer 502, and a spacing pattern 50S disposed between the first material layer 501 and the second material layer 502. The cavity 50C is formed between the first material layer 501 and the second material layer 502, so that the first bulk acoustic wave resonator 44 is floating above the substrate 42.

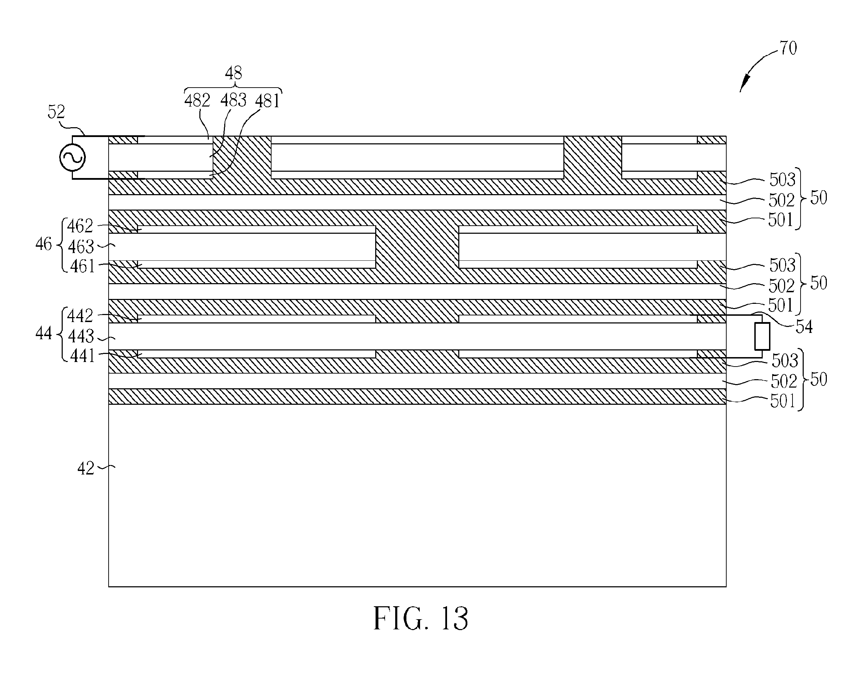

Please refer to FIG. 13. FIG. 13 is a schematic diagram illustrates a bulk acoustic wave filter and a method of fabricating the same according to another preferred embodiment of the present invention. As shown in FIG. 13, the method of fabricating a bulk acoustic wave filter 70 of this embodiment comprises the following steps. A substrate 42 is provided. A plurality of bulk acoustic wave resonators are formed on the substrate 42. For example, a first bulk acoustic wave resonator 44 is formed on the substrate 42, a plurality of second bulk acoustic wave resonators 46 are formed and stacked on the first bulk acoustic wave resonator 44, and a plurality of third bulk acoustic wave resonators 48 are formed. The bulk acoustic wave resonators are connected to each other by coupling, such as acoustical coupling or electrical coupling, to transmit a signal. In addition, an input end 52 and an output end 54 are formed, wherein the input end 52 and the output end 54 are electrically connected respectively to different bulk acoustic wave resonators, and the input end 52 and the output end 54 are disposed in different layers. For example, the input end 52 is electrically connected to the third bulk acoustic wave resonator 48 in the top layer, and the output end 54 is electrically connected to the first bulk acoustic wave resonator 44 in the bottom layer. Furthermore, in this embodiment, planar electrodes (as shown in FIG. 13) or patterned electrodes (as shown in FIG. 8 and FIG. 11) may be employed as the electrodes of the bulk acoustic wave resonators according to different design purposes. The above-mentioned approach, which electrically connects the input end 52 and the output end 54 respectively to the bulk acoustic wave resonators in different layers, may diversify the circuit designs of the bulk acoustic wave filter 70. In addiction, the interposer layer 50 in this embodiment may be formed by any one of the approaches described in the above-mentioned embodiment as needed.

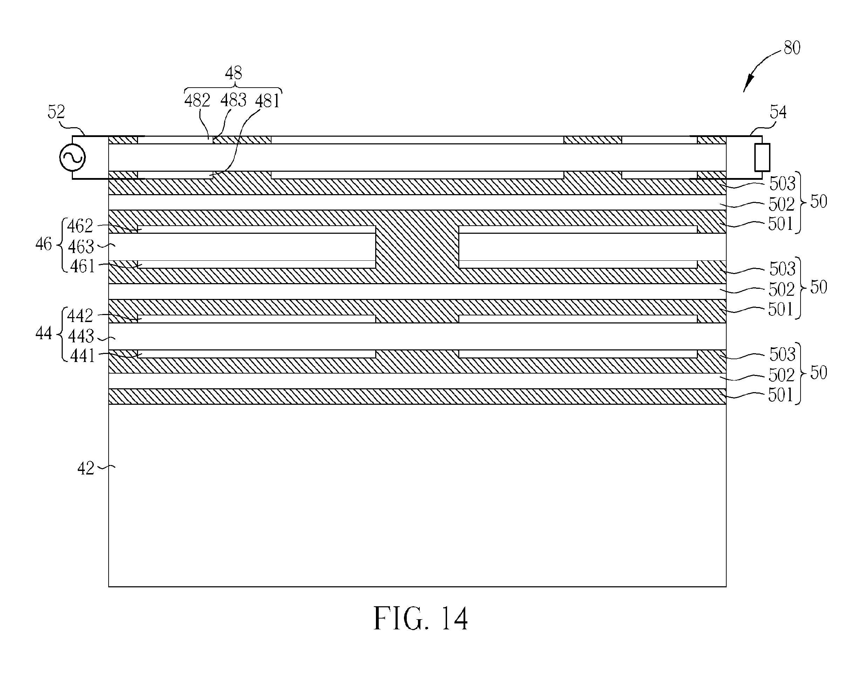

Please refer to FIG. 14. FIG. 14 is a schematic diagram illustrating a bulk acoustic wave filter and a method of fabricating the same according to further another preferred embodiment of the present invention. As shown in FIG. 14, a method of fabricating bulk acoustic wave filter 80 according to this embodiment comprises the following steps. A substrate 42 is provided. A plurality of bulk acoustic wave resonators are formed on the substrate 42. For example, a first bulk acoustic wave resonator 44 is formed on the substrate 42, a plurality of second bulk acoustic wave resonators 46 are formed and stacked on the first bulk acoustic wave resonators 44, and a plurality of third bulk acoustic wave resonators 48 are formed. The bulk acoustic wave resonators are connected to each other by coupling, such as acoustical coupling or electrical coupling, to transmit a signal. Each of the bulk acoustic wave resonators comprises two electrodes, and at least one piezoelectric layer disposed between the two electrodes. For example, each of the first bulk acoustic wave resonators 44 comprises a first electrode 441, a second electrode 442 disposed on the first electrode 441, and at least one piezoelectric layer 443 disposed between the first electrode 441 and the second electrode 442. Each of the second bulk acoustic wave resonators 46 comprises a first electrode 461, a second electrode 462 disposed on the first electrode 461, and at least one piezoelectric layer 463 disposed between the first electrode 461 and the second electrode 462. Each of the third bulk acoustic wave resonator 48 comprises a first electrode 481, a second electrode 482 disposed on the first electrode 481, and at least one piezoelectric layer 483 disposed between the first electrode 481 and the second electrode 482. In this embodiment, the piezoelectric layers of the bulk acoustic wave resonators in the top layer are interconnected to form a complete piezoelectric layer, i.e., at least a part of the piezoelectric layers 483 of the third bulk acoustic wave resonator 48 of bulk acoustic wave filter 80 in this embodiment are interconnected to form a complete piezoelectric layer. In addition, the design of the complete piezoelectric layer is not limited to be applied to the bulk acoustic wave resonators in the top layer. For example, the design of the complete piezoelectric layer may be applied to the bulk acoustic wave resonators in other layers as needed. In this embodiment, planar electrodes (as shown in FIG. 13) or patterned electrodes (as shown in FIG. 8 and FIG. 11) may be employed as the electrodes of the bulk acoustic wave resonators according to different design purposes. In addiction, the interposer layer 50 in this embodiment may be formed by any one of the approaches described in the above-mentioned embodiment as needed.

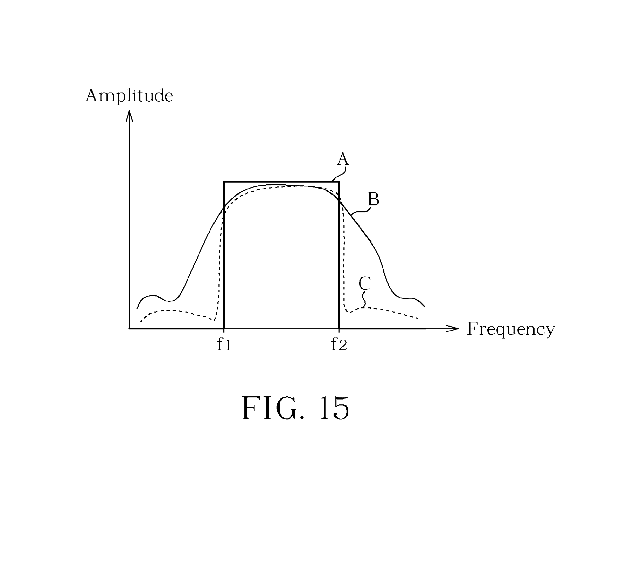

It is worth mentioning that the frequency tuning step according to the present invention is not limited to be used in adjusting the frequency of the bulk acoustic wave resonator, and the frequency tuning step may also be used in adjusting the operating frequency range of the bulk acoustic wave filter, i.e., the filtering performance of the bulk acoustic wave filter may be improved by individually adjusting the frequency of the different bulk acoustic wave resonators in the bulk acoustic wave filter. Please refer to FIG. 15. FIG. 15 is a schematic diagram illustrating the relationship between the amplitude and the frequency of the signals processed by the bulk acoustic wave filter. As shown in FIG. 15, A curve A is an ideal curve representing the relationship between the amplitude and the frequency of the processed by the bulk acoustic wave filter, A curve B is the actual curve representing the relationship between the amplitude and the frequency of the signals processed by the bulk acoustic wave filter, and a curve C is the actual curve representing the relationship between the amplitude and the frequency of the signals processed by the bulk acoustic wave filter after frequency tuning steps. As the curve A in FIG. 15 shows, in an ideal situation, the curve representing the relationship between the amplitude and the frequency of the signals processed by the bulk acoustic wave filter should be close to a rectangular shape, i.e., within the frequency range (from frequency f1 to frequency f2) of the signals capable of passing through, the intensity of the output signals should be equal, and there should be no signals outside the frequency range of the signals capable of passing through. As the curve B in FIG. 15 shows, in a real situation, the filtering performance of the bulk acoustic wave filter will be influenced by the process variation or other factors, and output signals with considerable intensity may be generated outside the frequency range of the signals, which are not supposed to pass through. As the curve C in FIG. 15 shows, after each of the frequencies of the bulk acoustic wave resonators being individually adjusted by the frequency tuning steps, the filtering performance of the bulk acoustic wave filter may be close to that the filtering performance of an ideal bulk acoustic wave filter, and then the reliability of the bulk acoustic wave filter is greatly improved.

In conclusion, the patterned electrodes may be used in the bulk acoustic wave resonator of the present invention, and be beneficial for realizing the frequency tuning steps. In addition, the input end and the output end of the bulk acoustic wave filter of the present invention are disposed in different layers, and the design of the circuit may then be diversified. Furthermore, the piezoelectric layers of bulk acoustic wave resonators of the bulk acoustic wave filter according to the present invention may be interconnected to form at least one piezoelectric layer. Additionally, each of the frequencies of the bulk acoustic wave resonators may be individually adjusted by the frequency tuning steps, the filtering performance of the bulk acoustic wave filter may then be close to the filtering performance of an ideal bulk acoustic wave filter, and the reliability of the bulk acoustic wave filter may be greatly improved.

## Claims

1. A bulk acoustic wave (BAW) resonator (38), comprising:
a substrate (30);
two electrodes (32, 36) stacked on the substrate (30); and
at least one piezoelectric layer (34) interposed between the two electrodes (32, 36);
**characterized in that** the two electrodes (32, 36) and the piezoelectric layer (34) at least partially overlap with each other in a vertical projection direction, and one of the two electrodes (32, 36) has a plurality of openings (32A, 36A).

2. The bulk acoustic wave resonator (38) according to claim 1, further **characterized in that** one of the two electrodes (32, 36) is a grid pattern electrode.

3. A method of fabricating a bulk acoustic wave (BAW) resonator (38), **characterized by**:
providing a substrate (30);
forming a first electrode (32) on the substrate (30);
forming at least one piezoelectric layer (34) on the first electrode (32);
forming a second electrode (36) on the piezoelectric layer (34); and
forming a plurality of openings (32A, 36A) in one of the first electrode (32) and the second electrode (36).

4. The method of fabricating the bulk acoustic wave resonator (38) according to claim 3, further **characterized by**:
changing numbers of the openings (32A, 36A) to decide a resonant frequency of the bulk acoustic wave resonator (38).

5. The method of fabricating the bulk acoustic wave resonator (38) according to claim 3, further **characterized by**:
changing areas of the openings (32A, 36A) to decide a resonant frequency of the bulk acoustic wave resonator (38).

6. The method of fabricating the bulk acoustic wave resonator (38) according to claim 3, further **characterized in that** the openings (32A, 36A) are arranged as a grid pattern.

7. A bulk acoustic wave filter (BAW filter) (70), comprising:
a substrate (42);
**characterized by**:
a plurality of bulk acoustic wave resonators (44, 46, 48) disposed on the substrate (42) in a multilayer stacked-up configuration, the bulk acoustic wave resonators (44, 46, 48) transmitting a signal by coupling; and
an input end (52) and an output end (54) electrically connected to different bulk acoustic wave resonators (44, 46, 48), respectively, the input end (52) and the output end (54) being disposed in different layers, respectively.

8. The bulk acoustic wave filter (70) according to claim 7, further **characterized in that** each of the bulk acoustic wave resonators (44, 46, 48) comprises two electrodes (441, 442, 461, 462, 481, 482) and at least one piezoelectric layer (443, 463, 483) interposed between the two electrodes (441, 442, 461, 462, 481, 482).

9. The bulk acoustic wave filter (70) according to claim 8, further **characterized by** at least one interposer layer (50) interposed between the bulk acoustic wave resonators (44, 46, 48) of different layers, and between the bulk acoustic wave resonators (44) of a bottom layer and the substrate (42).

10. The bulk acoustic wave filter (70) according to claim 9, further **characterized in that** the interposer layer (50) includes a piezoelectric layer or a dielectric layer.

11. The bulk acoustic wave filter (70) according to claim 9, further **characterized in that** the interposer layer (50) is a composite interposer layer, which includes a plurality of material layers (501, 502, 503) in the multilayer stacked-up configuration, and the material layers (501, 502, 503) have different acoustic impedances.

12. The bulk acoustic wave filter (70) according to claim 11, further **characterized in that** the composite interposer layer (50) has a cavity (50C) located among the material layers (501, 502).

13. The bulk acoustic wave filter (70) according to claim 7, further **characterized in that** the piezoelectric layers (443, 463, 483) of a portion of the bulk acoustic wave resonators (44, 46, 48) are interconnected to form at least one complete piezoelectric layer.

14. A method of fabricating bulk acoustic wave filter (BAW filter) (70), **characterized by**:
providing a substrate (42);
forming a plurality of bulk acoustic wave resonators (44, 46, 48) on the substrate (42), the bulk acoustic wave resonators (44, 46, 48) being disposed on the substrate (42) in a multilayer stacked-up configuration, and the bulk acoustic wave resonators (44, 46, 48) transmitting a signal by coupling; and
forming an input end (52) and an output end (54), the input end (52) and the output end (54) being electrically connected to different bulk acoustic wave resonators (44, 46, 48), respectively, and the input end (52) and the output end (54) being disposed in different layers, respectively.

15. A bulk acoustic wave filter (BAW filter) (80), comprising:
a substrate (42);
**characterized by** a plurality of bulk acoustic wave resonators (44, 46, 48) stacked on the substrate (42), the bulk acoustic wave resonators (44, 46, 48) transmitting a signal by coupling, each of the bulk acoustic wave resonators (44, 46, 48) including two electrodes (441, 442, 461, 462, 481, 482) and at least one piezoelectric layer (443, 463, 483) interposed between the two electrodes (441, 442, 461, 462, 481, 482), and the piezoelectric layers (443, 463, 483) of a portion of the bulk acoustic wave resonators (44, 46, 48) being interconnected to form at least one complete piezoelectric layer.

16. The bulk acoustic wave filter (80) according to claim 15, further **characterized by** an input end (54) and an output end (54), the input end (52) and the output end (54) being electrically connected to different bulk acoustic wave resonators (44, 46, 48), respectively, and the input end (52) and the output end (54) being disposed in different layers, respectively.

17. The bulk acoustic wave filter (80) according to claim 15, further **characterized by** at least one interposer layer (50) interposed between the bulk acoustic wave resonators (44, 46, 48) stacked-up.

18. The bulk acoustic wave filter (80) according to claim 17, further **characterized in that** the interposer layer (50) includes a piezoelectric layer or a dielectric layer.

19. The bulk acoustic wave filter (80) according to claim 17, further **characterized in that** the interposer layer (50) is a composite interposer layer, which includes a plurality of material layers (501, 502, 503) in a multilayer stacked-up configuration, and the material layers (501, 502, 503) have different acoustic impedances.

20. The bulk acoustic wave filter (80) according to claim 19, further **characterized in that** the composite interposer layer (50) has a cavity (50C) located among the material layers (501, 502).

21. A method of fabricating bulk acoustic wave filter (BAW filter) (80), **characterized by**:
providing a substrate (42); and
forming a plurality of bulk acoustic wave resonators (44, 46, 48) on the substrate (42), the bulk acoustic wave resonators (44, 46, 48) being stacked on the substrate (42), the bulk acoustic wave resonators (44, 46, 48) transmitting a signal by coupling, each of the bulk acoustic wave resonators (44, 46, 48) including two electrodes (441, 442, 461, 462, 481, 482) and at least one piezoelectric layer (443, 463, 483) interposed between the two electrodes (441, 442, 461, 462, 481, 482), and the piezoelectric layers (443, 463, 483) of a portion of the bulk acoustic wave resonators (44, 46, 48) being interconnected to form at least one complete piezoelectric layer.

22. A bulk acoustic wave filter (BAW filter) (40), further comprising:
a substrate (42);
**characterized by**:
a plurality of bulk acoustic wave resonators (44, 46, 48) stacked on the substrate (42), the bulk acoustic wave resonators (44, 46, 48) transmitting a signal by coupling, and each of the bulk acoustic wave resonators (44, 46, 48) including two electrodes (441, 442, 461, 462, 481, 482), and at least one piezoelectric layer (443, 463, 483) interposed between the two electrodes (441, 442, 461, 462, 481, 482), and
a conducting wire (49) electrically connected to the electrodes (441, 442, 461, 462, 481, 482) of the bulk acoustic wave resonators (44, 46, 48), the conducting wire (49) forming one of a capacitor, an inductor and a resistor.

23. The bulk acoustic wave filter (40) according to claim 22, further **characterized in that** the conducting wire (49) forms a capacitor, and a capacitance of the capacitor is determined by a length, a width, a thickness, a shape or a wiring pattern of the conducting wire (49).

24. The bulk acoustic wave filter (40) according to claim 22, further **characterized in that** the conducting wire (49) forms an inductor, and an inductance of the inductor is determined by a length, a width, a thickness, a shape or a wiring pattern of the conducting wire (49).

25. The bulk acoustic wave filter (40) according to claim 22, further **characterized in that** the conductive wire (49) forms a resistor, and a resistance of the resistor is determined by a length, a width, a thickness, a shape or a wiring pattern of the conducting wire (49).
